Europäisches Patentamt

European Patent Office

Office européen des brevets

(19)

(11) Numéro de publication: **0 055 968**
**A2**

(12)

# DEMANDE DE BREVET EUROPEEN

(21) Numéro de dépôt: **81402096.2**

(22) Date de dépôt: **31.12.81**

(51) Int. Cl.³: **H 01 L 29/80**
**H 01 L 29/10, H 01 L 29/62**
**H 01 L 29/36**

(30) Priorité: **06.01.81 FR 8100096**

(43) Date de publication de la demande:
**14.07.82 Bulletin 82/28**

(84) Etats contractants désignés:
**DE GB IT**

(71) Demandeur: **THOMSON-CSF**
**173, Boulevard Haussmann**
**F-75360 Paris Cedex 08(FR)**

(72) Inventeur: **Nuyen, Trong Linh**
**THOMSON-CSF SCPI 173, bld Haussmann**
**F-75360 Paris Cedex 08(FR)**

(72) Inventeur: **DeLagebeaudeuf, Daniel**
**THOMSON-CSF SCPI 173, bld Haussmann**
**F-75360 Paris Cedex 08(FR)**

(74) Mandataire: **Taboureau, James et al,**
**THOMSON-CSF SCPI 173, Bld Haussmann**
**F-75360 Paris Cedex 08(FR)**

(54) Transistor à effet de champ à faible temps de commutation du type normalement bloquant.

(57) L'invention concerne les transistors à effet de champ, fonctionnant à fréquence élevée, et qui sont bloqués en l'absence d'une tension de polarisation sur la grille.

Dans les transistors selon l'invention, le canal entre source et drain est constitué par une couche d'électrons à haute mobilité à l'interface d'une hétérojonction entre un matériau semiconducteur ayant une large bande interdite et un matériau ayant une bande interdite plus étroite, mais de même paramètre de maille cristalline, la composition, le dopage et l'épaisseur des couches étant choisis pour que le transistor soit bloqué sous polarisation nulle.

Application aux dispositifs hyperfréquence.

**FIG.10**

EP 0 055 968 A2

## TITRE MODIFIÉ
### voir page de garde.

### TRANSISTOR A FAIBLE TEMPS DE COMMUTATION, DE TYPE NORMALEMENT BLOQUANT

La présente invention concerne les perfectionnements aux dispositifs semi-conducteurs de type transistor à effet de champ, et plus spécialement ceux dont le temps de commutation est faible et dont le fonctionnement est du type normalement bloquant, dont le canal du transistor n'est pas conducteur en absence de polarisation sur la grille.

Il existe plusieurs sortes de transistors à effet de champ connus. Leur classification fait intervenir soit leurs structures, soit leur mode de fonctionnement.

Selon la classification relative aux structures, on distingue trois principales familles.

La première comporte un substrat semi-isolant, surmonté d'une couche active dopée généralement de type N, à une concentration électronique de l'ordre de $10^{17}$ électrons/$cm^{-3}$. Les contacts de source et de drain sont déposés de part et d'autre du contact de grille. Selon la nature du contact de grille, on distingue :

- les MESFET (en anglais Metal Semiconductor field transistor) à grille Schottky.

- les JFET à grille à jonction P-N.

- les HJFET à grille à hétérojonction P-N où le semiconducteur constituant la grille est de nature différente de celle constituant la couche active.

- les IGFET (en anglais insulated gate field effect transistor) où une couche d'isolant est intercallée entre la couche active et le métal de contact. Ces transistors sont quelquefois appelés MOSFET (metal oxide semiconductor field effect transistor) ou MISFET (metal insulator semiconductor field effect transistor). Ces dernières appellations ne seront pas utilisées dans la suite du texte pour ne pas créer de confusion avec les transistors MOS ou MIS dont les définitions sont données après.

L'ensemble des transistors MESFET, JFET, HJFET, IGFET possède la propriété commune suivante : sous la grille se développe une région de charge d'espace dont l'épaisseur est modulable par la tension de grille. On module ainsi le courant source-drain. Entre source et grille d'une part et grille et drain d'autre part, se développent respectivement deux régions de charge d'espace dont l'épaisseur, fixée par le potentiel de surface du semiconducteur, n'est pas modulable par la tension grille. Les épaisseurs des régions de charge d'espace sont plus faibles que celle de la région à polarisation nulle.

La deuxième famille de transistor à effet de champ est constituée par les MOS ou MIS (en anglais metal-oxide-semiconductor ou metal-insulator-semiconductor) à inversion de type de charge. Le canal du transistor peut être de type N ou P. Dans un MOS à canal N : sur un substrat de type P sont définis deux caissons $N^+$ sur lesquels sont déposés les contacts de source et de drain. La grille est formée par une mince couche d'oxyde ou d'isolant recouvrant la surface du substrat entre les caissons $N^+$. Le contact métallique de grille est déposé sur la couche d'oxyde ou d'isolant. Pour une forte polarisation positive de la grille, il se crée une zone d'inversion de type de charge sous la grille. En d'autres termes, un canal de type N est formé dont la densité de charge est modulable par la tension de grille.

La troisième famille de transistors à effet de champ possède la particularité d'avoir pour canal une couche d'électrons de haute mobilité ($7000$ $cm^2.v.^{-1}.s^{-1}$ à $300^o$ K et $50.000$ $cm^2.v^{-1}.s^{-1}$ à $77^oK$) accumulés à l'interface d'une hétérojonction par exemple de GaAs et $Al_x Ga_{1-x}$ As. Afin de simplifier le texte et les figures, on emploiera par la suite le sigle AlGaAs au lieu de $Al_x Ga_{1-x}$ As. Ce type de transistor a été décrit par D. DELAGEBEAUDEUF, P. DELESCLUSE, P. ETIENNE, M. LAVIRON, J. CHAPLART et NUYEN T.LIHN dans Electronics Letters (1980) 16, 667. Il possède une structure d'hétérojonction formée par un premier semiconducteur à grande bande interdite et un second semiconducteur à petite bande interdite. La couche d'accumulation d'électrons est à l'interface des deux semiconducteurs. La commande de la charge d'accumulation peut se faire de plusieurs manières :

- selon la demande de brevet n° 79 07 803 de la demanderesse, la grille est constituée par un contact ohmique déposé sur AlGaAs.

- selon la demande de brevet n° 79 22 586 de la demanderesse, la grille est constituée par un contact Schottky déposé sur la couche de GaAs.

- selon la demande de brevet n° 80 21 942 de la demanderesse, la grille est constituée par un contact Schottky déposé sur le semi-conducteur à grand gap.

- selon les demandes de brevet n° 79 22 30 et 79 26 611 de la demanderesse, la grille est constituée par un contact métallique déposé sur un isolant, qui est lui-même en contact avec la couche de AlGaAs.

Selon la classification des transistors à effet de champ relative au mode de fonctionnement on distingue :

a - les transistors normalement passants, c'est à dire qu'en absence de polarisation grille, un courant passe entre source et drain.

b - les transistors normalement bloquants.

L'utilisation des transistors normalement bloquants, dans les circuits logiques, présente par rapport aux transistors normalement passants, des avantages considérables : faible consommation d'énergie, simplicité du circuit et d'alimentation en tension.

Les transistors MOS (ou MIS) décrits dans la seconde famille de structure sont normalement bloquants. Ils sont très utilisés dans les circuits intégrés. Mais la mobilité électronique dans ces transistors est faible, inférieure à 1000 $cm^2v^{-1}s^{-1}$, ce qui limite le temps de commutation de ces transistors.

Les transistors décrits dans la première famille de structure (MESFET, JFET, etc...) sont souvent réalisés avec des matériaux de plus haute mobilité (4000-4500 $cm^2v^{-1}s^{-1}$) tel que GaAs. Ils sont donc particulièrement intéressants à ce point de vue, mais leur utilisation en tant que transistor normalement bloquant est difficile. En effet, ils ne sont normalement bloquant que si l'épaisseur de la couche active ne dépasse pas celle de la zone dépeuplée sous la grille à polarisation nulle. Cette épaisseur est de l'ordre de 800 à 1000 Å selon le type de grille et le dopant utilisés. Mais l'épaisseur de la couche active ne doit pas être moindre que celles des zones dépeuplées naturellement sous la surface libre. Cette épaisseur est de l'ordre de 600 Å. L'intervalle très faible dans laquelle doit se situer l'épaisseur de la couche active a pour conséquence une grande difficulté de réalisation pratique et surtout l'existence de résistances source-grille et drain-grille élevées.

Les transistors décrits dans la troisième famille de structure fonctionnent sous le régime normalement passant.

L'objet de la présente invention est de remédier à ces limitations en utilisant des structures de transistor à effet de champ dont le canal est constitué par une couche d'électrons à haute mobilité électronique accumulés à l'interface d'une hétérojonction et en contrôlant le dopage, la composition et l'épaisseur des couches constituant l'hétérojonction, afin de rendre la densité de charge électronique d'accumulation compatible avec une structure normalement bloquante.

De façon plus précise, l'invention en un transistor à effet de champ à faible temps de commutation, de type normalement bloquant, comportant, supportées par un substrat semi-isolant, une première couche active faiblement dopée de type N ou P, une seconde couche située entre la première couche et une grille métallique, et deux contacts dits de source et de drain, ce transistor étant caractérisé en ce que la seconde couche est constituée par un semiconducteur ayant une bande interdite plus grande que celle de la première couche active et possédant un paramètre de maille compatible avec celui de la première couche, et en ce que la composition, le dopage et l'épaisseur de la seconde couche sont choisis pour que, sous une faible polarisation positive sur la grille, de quelques dixièmes de volt, une accumulation d'électrons est créée dans la première couche à l'interface des première et seconde couches, et que le transistor soit bloqué par réduction de la polarisation de grille jusqu'à une valeur nulle.

L'invention sera mieux comprise par la description des exemples d'applications qui suivent, laquelle s'appuie sur les figures jointes qui représentent :

-figure 1 : la structure d'un transistor à effet de champ connu, selon la première famille de structure ;

- figure 2 : la structure d'un transistor à effet de champ connu, selon la deuxième famille de structure ;

- figure 3 : le diagramme de bandes de la structure MOS pour une polarisation nulle de grille ;

- figure 4 : le diagramme de bandes de la structure MOS pour une polarisation positive de la grille ;

- figure 5 : la structure d'hétérojonction d'un transistor à effet de champ connu, selon la troisième famille de structure ;

- figure 6 : le diagramme de bandes d'une structure de transistor à couche d'accumulation d'électrons, la grille Schottky étant déposée sur le semi-conducteur à grand gap, telle qu'il a été décrit dans la demande de brevet n° 80 21 942,c 'est à dire que GaAs est faiblement dopé de type N et AlGaAs dopé de type N, à un niveau supérieur à $10^{17}$ $cm^{-3}$ ;

- figure 7 : le diagramme de bandes d'une structure de transistor selon l'invention dans laquelle la couche en AlGaAs est suffisamment mince pour que la déplétion sous la grille Schottky atteigne la couche d'accumulation et la vide d'électrons ;

- figure 8 : le diagramme de bandes de la structure précédente avec une polarisation positive sur la grille ;

- figure 9 : un premier exemple de réalisation de transistor selon l'invention ;

- figure 10 : un deuxième exemple de réalisation de transistor selon l'invention ;

- figure 11 : le diagramme de bandes d'une structure dans laquelle la couche en AlGaAs n'est pas dopée de type N mais est de haute résistivité ;

-figure 12 : un troisième exemple de réalisation de transistor selon l'invention.

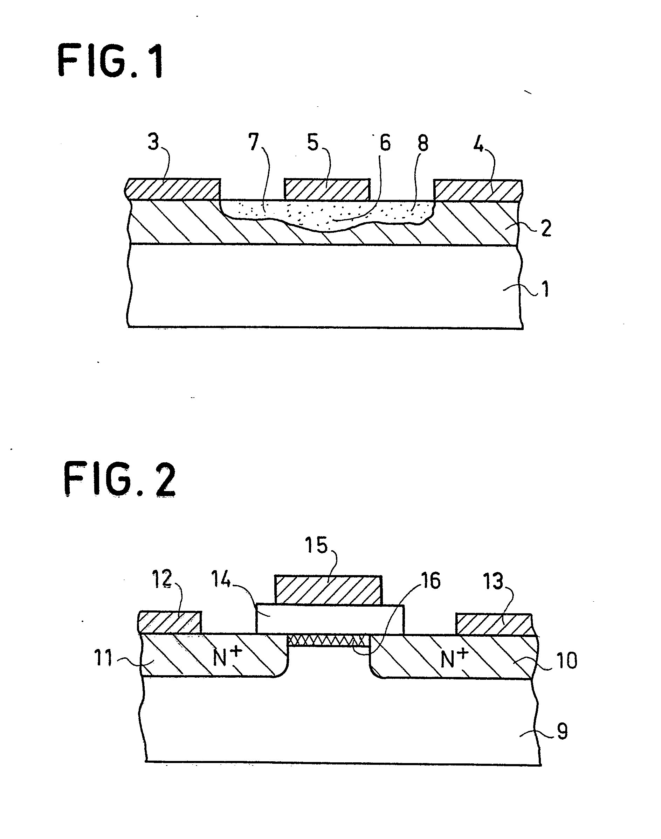

La figure 1 représente la structure d'un transistor à effet de champ connu, selon la première famille de structures (MESFET, JFET...).

Sur le substrat 1, semi-isolant, est déposée une couche active 2, de type N. Les contacts 3 de source et 4 de drain sont déposés de part et d'autre du contact 5 de grille. Les régions de charge d'espace sont en 6 sous la grille, en 7 et 8 entre grille et source, et grille et drain.

La figure 2 représente la structure d'un transistor à effet de champ connu, selon la seconde famille de structures, du type MOS à canal N.

Sur le substrat 9, de type P, sont définis deux caissons $N^+$ 10 et 11, qui supportent les contacts 12 de source et 13 de drain. Le contact 15 de grille est déposé sur une couche 14 d'oxyde ou d'isolant qui recouvre la surface du substrat entre les deux caissons N$^+$. Une zone d'inversion de charge 16 se forme sous la grille, sous forte polarisation positive.

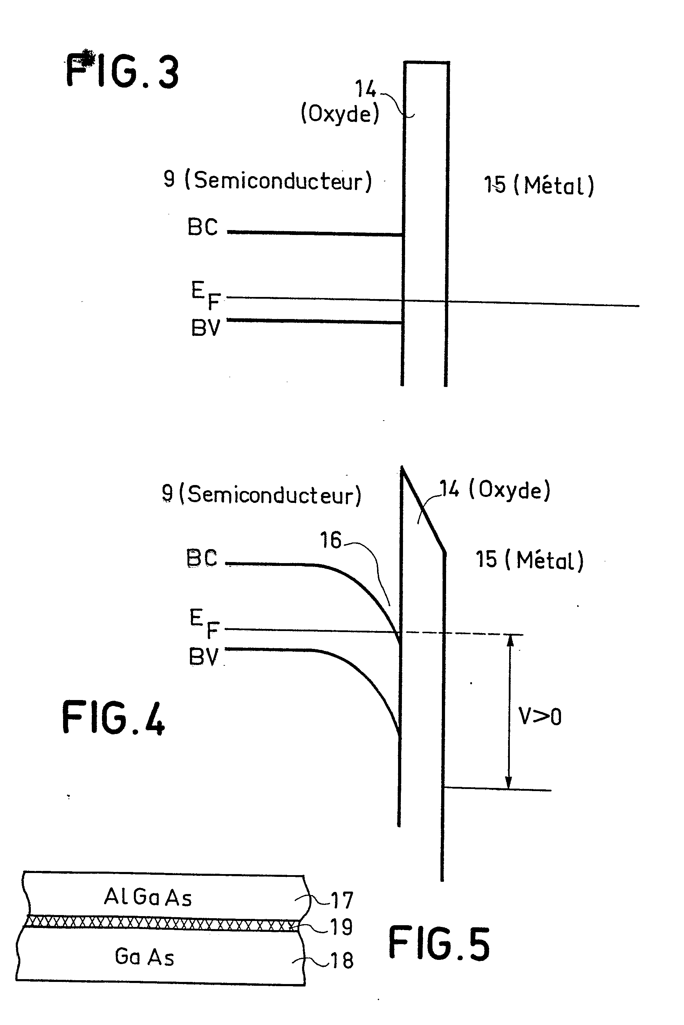

La figure 3 montre le diagramme de bandes de la structure MOS ou MIS de la figure 2, sous polarisation nulle. Les droites BC, BV et EF désignent respectivement la bande de conduction, la bande de valence et le niveau de Fermi. Il n'y a pas de charges négatives sous polarisation nulle.

Celles-ci sont mises en évidence, en 16, sur la figure 4 qui correspond à la figure 3, mais sous une forte polarisation positive de la grille.

La figure 5 représente la structure d'hétérojonction d'un transistor à effet de champ connu selon la troisième famille de structure. L'hétérojonction est formée entre un premier semiconducteur 17 à grande bande interdite, du type AlGaAs, et un second semiconducteur 18 à petite bande interdite, du type GaAs. Le canal est formé par une couche 19 d'accumulation d'électrons de haute mobilité.

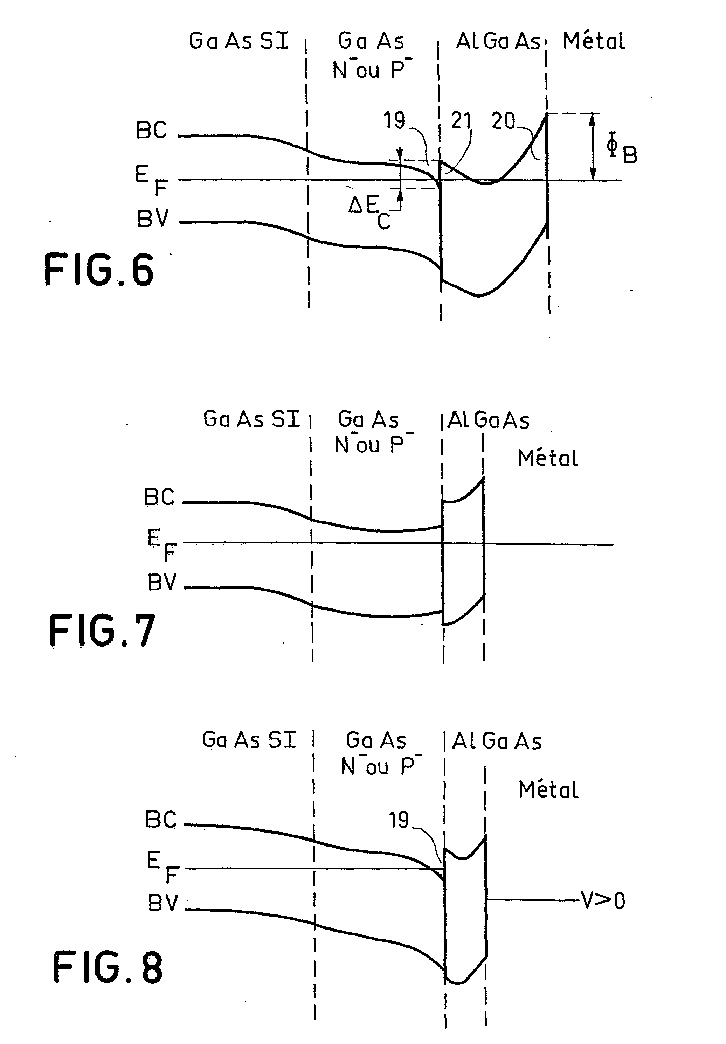

La figure 6 rappelle le diagramme de bandes de la structure de transistor à accumulation d'électrons selon la demande de brevet n° 80 21 942 de la demanderesse.

La structure comporte un substrat en GaAs semi-isolant (SI), une couche en GaAs faiblement dopé N⁻ ou P⁻, une couche en AlGaAs dopé de type N à un niveau supérieur à $10^{17}$ e⁻/cm$^3$, et un métal. BC, BV et $E_F$ désignent respectivement le niveau d'énergie de la bande de conduction, de la bande de valence et du niveau de Fermi. $\Phi_B$ et $\Delta E_c$ désignent respectivement la hauteur de barrière de Schottky métal-AlGaAs et la discontinuité dans la bande de conduction à l'interface de GaAs et AlGaAs. La couche d'accumulation d'électrons de haute mobilité est désignée par 19. Dans la couche de AlGaAs existent deux zones de désertion d'électrons, l'une 20 relative à la diode Schottky, l'autre 21, relative à l'hétérojonction. Si la couche en AlGaAs est suffisamment épaisse, les deux zones 20 et 21 sont distinctes. Sinon elles s'interpénètrent.

Sur la figure 7, cette interpénétration est suffisamment importante, c'est à dire que la couche en AlGaAs est suffisamment mince pour que la couche d'accumulation d'électrons soit détruite. Cependant on peut, par une polarisation positive (fig.8) appliquée sur le contact Schottky, créer une accumulation d'électrons 19 à l'interface de GaAs et AlGaAs.

7

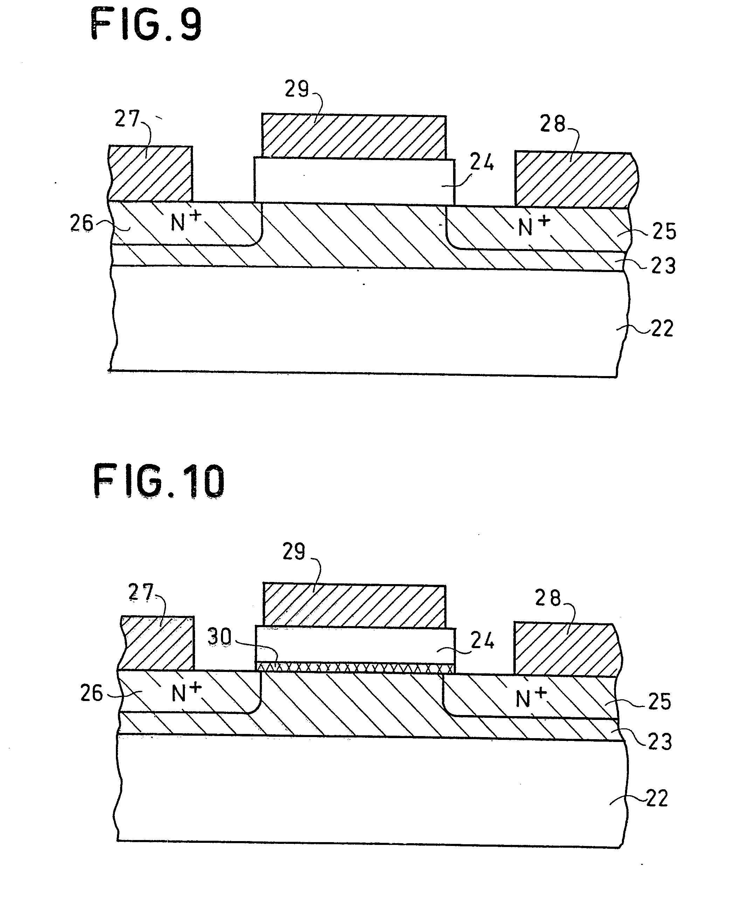

La figure 9 représente un premier exemple de transistor selon l'invention, basé sur le mécanisme de formation et de destruction de la couche d'accumulation d'électrons tel qu'elle vient d'être décrite.

Sur un substrat 22 en GaAs SI sont déposées successivement par épitaxie, une couche 23 en GaAs faiblement dopée de type $N^-$ ou $P^-$ à environ $10^{14}$ cm$^{-3}$, et une couche 24 en AlGaAs de type N dopé à un niveau compris entre $10^{17}$ et $10^{18}$ électrons/cm$^3$. Par opération de lithographie classique, on dégage un mésa dans AlGaAs sur une distance équivalente à la longueur de grille et l'on forme, par implantation ou diffusion, deux caissons $N^+$ 25 et 26 qui pénètrent légèrement sous la grille 24 en AlGaAs. Deux contacts ohmiques 27 et 28 sont déposés sur ces caissons et jouent respectivement le rôle de contact de source et de drain. Un contact Schottky 29 est déposé sur la couche 24 AlGaAs, et joue le rôle de contact de grille. L'épaisseur de la couche 24 en AlGaAs est faible (200 à 700 Å environ). Comme il a été exposé précédemment, la couche d'accumulation est détruite à polarisation nulle sur la grille. Autrement dit entre source et drain, la couche en GaAs n'est pas conductrice et il n'y passe pas de courant : le transistor est normalement bloquant. Lorsque l'on applique une tension positive suffisamment forte sur la grille Schottky, il se forme une couche d'accumulation 19 telle que décrite précédemment sur la figure 8. La tension seuil à laquelle le transistor devient passant est de l'ordre de quelques dixièmes de volt. L'existence des caissons $N^+$ qui viennent juste sous la grille 24 permet de réduire fortement les zones de déplétion sous une surface libre telles que les régions 7 et 8 de la figure 1. Les résistances source-grille et drain-grille sont donc minimisées. Par ailleurs l'existence d'une barrière de potentiel $\Delta E_c$ entre les couches 23 et 24 permet d'éviter les courants de fuite vers la grille.

Plusieurs perfectionnements peuvent être apportés à cette structure.

En premier lieu, selon la figure 10, afin d'accroître la mobilité des électrons dans la couche d'accumulation, on minimise la diffusion des impuretés donneurs de la couche 24 vers la couche 23 en intercallant entre ces deux couches, une couche 30 très mince non dopée, de l'ordre de plusieurs dizaines d'Å. Cette couche permet aussi de diminuer l'intéraction coulombienne entre les impuretés et les électrons, donc d'accroître la mobilité des électrons.

La couche 30 permet en outre de réduire les courants de fuite entre la source 27 et la grille 29.

En second lieu, on peut améliorer la tenue en tension positive de la grille Schottky en dopant faiblement la couche 24 dans la zone proche de la grille 29, à un niveau inférieur à $5.10^{16}$ électrons, $cm^3$.

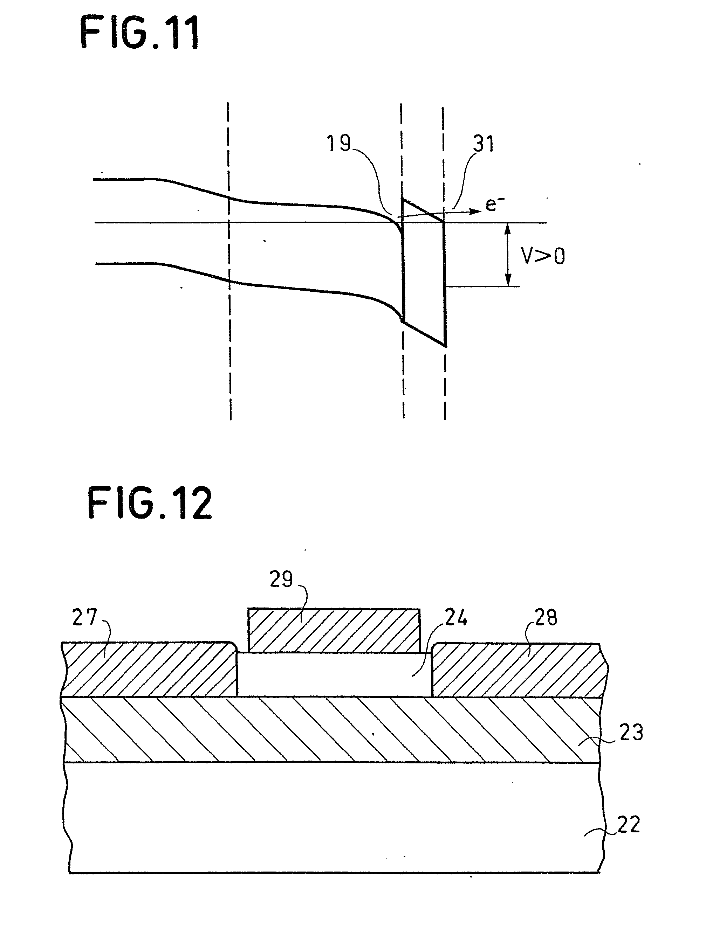

Une autre variante du transistor selon l'invention, consiste à ne pas doper la couche 24 en AlGaAs. Dans ce cas l'apparition d'une couche d'accumulation a lieu à une tension seuil plus élevée que celle obtenue sur les structures précédentes. L'utilisation d'une tension seuil trop élevée risque cependant de créer un transfert d'électrons par effet tunnel de la couche 19 vers la grille 29 comme l'indique le trajet 31 sur la figure 11. Afin de réduire, voire éliminer cet effet tunnel il faut accroître la barrière de potentiel $\Delta E_c$, c'est à dire augmenter la concentration en aluminium dans la couche 24. Cependant une trop forte concentration en aluminium dans la couche 24 peut nuire à la qualité de l'interface de l'hétérojonction. Une solution qui permet de réduire l'effet tunnel sans dégrader l'interface de l'hétérojonction est d'utiliser une couche en AlGaAs avec une composition croissante en aluminium depuis l'interface de l'hétérojonction jusqu'à la grille Schottky.

La figure 12 représente un troisième exemple de réalisation du transistor selon l'invention.

L'utilisation d'une couche en AlGaAs non dopé donc non conducteur permet de donner au transistor une autre configuration selon laquelle les métallisations 27 de source et 28 de drain viennent en contact avec la couche 24 en AlGaAs non conducteur, cette couche étant soit à composition en aluminium constante soit à composition variable tel qu'il a été exposé précédemment. La métallisation 29 de grille est alors de dimensions plus petites que la couche 24, pour éviter les contacts avec les métallisations de source et de drain.

L'absence de surface libre entre source et grille et entre grille et drain élimine donc le problème de résistance d'accès liée aux zones de direction d'électrons en surface.

Un transistor ayant une telle configuration fonctionne avec ou sans les caissons $N^+$ 25 et 26. En effet, quelque soit le cas, le courant circule entre source et grille et entre drain et grille puisque les métallisations de source et de drain sont directement au contact de la couche 24 en AlGaAs.

L'ensemble de ces considérations, qui a été développé pour le couple GaAs-$Al_xGa_{1-x}$As, peut être étendu à d'autres couples de matériaux de la famille des composés III-V, associant un semiconducteur à petite bande interdite à un semiconducteur à grande bande interdite ayant un paramètre de maille identique au premier. Ce sont par exemple :

– GaAs associé à $Ga_xIn_{1-x}P$, $Al_xIn_{1-x}P$, $AlP_xSb_{1-x}$, $Al_xGa_{1-x}P_ySb_{1-y}$ ou $Ga_xIn_{1-x}P_ySb_{1-y}$ ;

– InP associé à $Al\,As_xSb_{1-x}$ ou $AlP_xSb_{1-x}$ ;

– $Ga_xIn_{1-x}As$ associé à InP, $Al_xIn_{1-x}As$, $Al\,As_xSb_{1-x}$ ou $AlP_xSb_{1-x}$.

Les indices x et y sont liés de telle façon qu'à une variation de x correspond une variation de y telle que le paramètre de maille reste adapté à celui du substrat.

REVENDICATIONS

1. Transistor à effet de champ à faible temps de commutation, de type normalement bloquant, comportant, supportées par un substrat semi-isolant (22), une première couche active (23) faiblement dopée de type N ou P, une seconde couche (24) située entre la première couche (23) et une grille métallique (29), et deux contacts dits de source (27) et de drain (28), ce transistor étant caractérisé en ce que la seconde couche (24) est constituée par un semiconducteur ayant une bande interdite plus grande que celle de la première couche active (23) et possédant un paramètre de maille compatible avec celui de la première couche (23), et en ce que la composition, le dopage et l'épaisseur de la seconde couche (24) sont choisis pour que, sous une faible polarisation positive sur la grille, de quelques dixièmes de volt, une accumulation d'électrons est créée dans la première couche (23) à l'interface des première et seconde couches (23 et 24), et que le transistor soit bloqué par réduction de la polarisation de grille jusqu'à une valeur nulle.

2. Transistor à effet de champ selon la revendication 1, caractérisé en ce que :

- le substrat semi-isolant est constitué par GaAs

- le semiconducteur de la première couche (23) est GaAs

- le semiconducteur de la deuxième couche (24) est l'un quelconque des alliages suivants parmi : $Al_xGa_{1-x}As$, $Ga_xIn_{1-x}P$, $Al_xIn_{1-x}P$, $Al\,P_xSb_{1-x}$, $Al_xGa_{1-x}P_ySb_{1-y}$ ou $Ga_xIn_{1-x}P_ySb_{1-y}$.

3. Transistor à effet de champ selon la revendication 1, caractérisé en ce que :

- le substrat semi-isolant est constitué par InP

- le semiconducteur de la première couche (23) est InP

- le semiconducteur de la deuxième couche (24) est en $Al\,As_xSb_{1-x}$ ou $Al\,P_xSb_{1-x}$.

4. Transistor à effet de champ selon la revendication 1, caractérisé en ce que :

- le substrat semi-isolant est en InP

- le semiconducteur de la première couche (23) est en $Ga_xIn_{1-x}As$

- le semiconducteur de la deuxième couche (24) est l'un quelconque des alliages suivants parmi : InP, $Al_x In_{1-x} As$, $Al As_x Sb_{1-x}$ ou $Al P_x Sb_{1-x}$.

5. Transistor à effet de champ selon l'une quelconque des revendications 2, 3 ou 4 caractérisé en ce que la seconde couche (24) est dopée de type N à un niveau compris entre $10^{17}$ à $10^{18}$ électrons/$cm^3$ et en ce que son épaisseur est comprise entre 200 et 700 Å.

6. Transistor à effet de champ selon la revendication 5, caractérisé en ce qu'une couche non dopée 30, de même matériau que la seconde couche (24) et d'épaisseur de plusieurs dizaines d'angstroms, est intercallée entre la première couche (23) et la seconde couche (24).

7. Transistor à effet de champ selon la revendication 6, caractérisé en ce que la seconde couche (24) est dopée, dans la zone située à l'interface avec la grille (29), à un niveau inférieur à $5.10^{16}$ électrons/$cm^3$.

8. Transistor à effet de champ selon l'une quelconque des revendications 2, 3 ou 4, caractérisé en ce que la seconde couche (24) est isolante.

9. Transistor à effet de champ selon l'une quelconque des revendications 2, 3 ou 4, caractérisé en ce que la seconde couche (24) présente un gradient de composition de telle façon que la bande interdite croît depuis l'interface avec la première couche (23) vers la grille (29).

10. Transistor à effet de champ selon l'une quelconque des revendications 5, 6 ou 7, caractérisé en ce que deux caissons $N^+$ (25 et 26) fortement dopés pénètrent légèrement sous la grille (24) et en ce que les contacts (27) de source et (28) de drain sont déposés respectivement sur les caissons (25 et 26).

11. Transistor à effet de champ selon l'une quelconque des revendications 8 ou 9, caractérisé en ce que les métallisations (27) de source et (28) de drain sont en contact avec les bords de la seconde couche (24), la métallisation (29) de grille étant de dimensions plus petites que la seconde couche (24), et en ce que le courant passe des métallisations (27) de source et (28) de drain vers la métallisation (29) de grille directement par la seconde couche (24).

0055968

1/5

FIG. 1

FIG. 2

FIG.3

14 (Oxyde)

9 (Semiconducteur)

15 (Métal)

BC

$E_F$

BV

9 (Semiconducteur)

14 (Oxyde)

16

BC

15 (Métal)

$E_F$

BV

FIG.4

V>0

Al Ga As ⎯ 17

⎯ 19

Ga As ⎯ 18

FIG.5

0055968

GaAs SI | GaAs | AlGaAs | Métal
         | N⁻ou P⁻ |

BC

$E_F$

$\Delta E_C$

BV

$\phi_B$

19    21    20

## FIG.6

GaAs SI | GaAs | AlGaAs
         | N⁻ou P⁻ |

Métal

BC

$E_F$

BV

## FIG.7

GaAs SI | GaAs | AlGaAs
         | N⁻ou P⁻ |

Métal

BC

$E_F$

BV

19

V>0

## FIG.8

FIG.9

FIG.10

FIG.11

FIG.12